# EUROPEAN PATENT APPLICATION

(11) **EP 4 766 060 A2**
(43) Date of publication of application: **24.06.2026**
(21) Application number: 25225942.9
(22) Date of filing: 19.12.2025
(51) Int. Cl.: H05K 7/20

(54) **ELECTRONIC COMPONENT COOLING ASSEMBLY**

(30) Priority: 23.12.2024 US 202418999038
(71) Applicant: General Electric Company, Cincinnati, Ohio 45215 (US)
(72) Inventor: ESLER, David Richard, Niskayuna, 12309 (US); GOWDA, Arun, Niskayuna, 12309 (US); RUSH, Brian Magann, Niskayuna, 12309 (US); YIN, Liang, Niskayuna, 12309 (US)
(74) Representative: Openshaw & Co.

(57) **Abstract**

An electronic component cooling assembly includes an electronic component and a housing defining a slot such that at least a portion of the electronic component is positioned within the slot. The housing further defining an impingement cooling passage fluidly coupled to the slot. The electronic component cooling assembly includes a thermal insert positioned between the electronic component and the housing in the vertical direction, with the thermal insert defining a chamber such that the impingement cooling passage directs a fluid jet into the chamber and onto the electronic component. The thermal insert further defines a cavity spaced apart from the chamber in the longitudinal and/or the transverse direction. Additionally, the electronic component cooling assembly includes a phase change material positioned within the cavity and configured to absorb heat from the electronic component.

## Description

### FEDERALLY SPONSORED RESEARCH

This invention was made with government support under contract number W911NF1820101 awarded by the Department of Defense. The U.S. government may have certain rights in the invention.

### FIELD

The present disclosure is related to electronic component cooling assemblies and, more specifically, to electronic component cooling assemblies for use in power systems.

### BACKGROUND

Power systems manage the supply of electrical power from one or more power sources, such as a generator(s), to one or more electrical loads. In this respect, power systems are prevalent and found in many different applications. For example, on an aircraft, one or more gas turbine engines, which are primarily used to generate propulsive thrust, can provide mechanical power to various electrical power-generating components on the aircraft, such as generators, alternators, starter/generators, and the like. The electric power generated by such components can then be used to power avionics, electric motors, and other electrical equipment. As such, a power system may control the flow of electrical power from the power-generating components to the electrical equipment.

In certain infrequent instances, a larger than-normal amount of power can be drawn by the electrical equipment. This, in turn, results in a large amount of current flowing through the power system, thereby creating a large amount of heat that must be dissipated. In this respect, most conventional power systems include components designed and sized to accommodate these high current/power events even though such events are relatively short (e.g., less than five minutes) and infrequent. The larger power system components sized to handle such conditions are heavier than the smaller components, which can add significant weight to the power system. Increased power system weight can be undesirable in certain applications, such as in aircraft or other aerospace applications where weight increases can dramatically increase energy consumption.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1 is a simplified cross-sectional view of one embodiment of an electronic component cooling assembly in accordance with an exemplary aspect of the present disclosure.
FIG. 2 is a top view of one embodiment of one embodiment of an electronic component in accordance with an exemplary aspect of the present disclosure.
FIG. 3 is a cross-sectional view of the electronic component taken about Line 3-3 in FIG. 2.
FIG. 4 is a partial, enlarged cross-sectional view of the electronic component cooling assembly shown in FIG. 1, particularly illustrating flow of fluid through the assembly in accordance with an exemplary aspect of the present disclosure.
FIG. 5 is another partial, enlarged cross-sectional view of the electronic component cooling assembly shown in FIG. 1, particularly illustrating one embodiment of a thermal insert of the electronic component cooling assembly in accordance with an exemplary aspect of the present disclosure.
FIG. 6 is a top view of the thermal insert in accordance with an exemplary aspect of the present disclosure.
FIG. 7 is a partial, enlarged cross-sectional view of the electronic component cooling assembly shown in FIG. 1, particularly illustrating another embodiment of the thermal insert in accordance with an exemplary aspect of the present disclosure.
FIG. 8 is a partial, enlarged cross-sectional view of the electronic component cooling assembly shown in FIG. 1, particularly illustrating a further embodiment of a thermal insert in accordance with an exemplary aspect of the present disclosure.
FIG. 9 is a partial, enlarged cross-sectional view of the electronic component cooling assembly shown in FIG. 1, particularly illustrating yet another embodiment of a thermal insert in accordance with an exemplary aspect of the present disclosure.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise.

The term "at least one of" in the context of, e.g., "at least one of A, B, and C" refers to only A, only B, only C, or any combination of A, B, and C.

The terms "coupled," "fixed," "attached to," and the like refer to both direct coupling, fixing, or attaching, as well as indirect coupling, fixing, or attaching through one or more intermediate components or features, unless otherwise specified herein.

As used herein, the terms "first", "second", and "third" may be used interchangeably to distinguish one component from another and are not intended to signify location or importance of the individual components.

For purposes of the description hereinafter, the terms "upper", "lower", "right", "left", "vertical", "horizontal", "top", "bottom", "lateral", "longitudinal", and derivatives thereof shall relate to the embodiments as they are oriented in the drawing figures. However, it is to be understood that the embodiments may assume various alternative variations, except where expressly specified to the contrary. It is also to be understood that the specific devices illustrated in the attached drawings, and described in the following specification, are simply exemplary embodiments of the disclosure. Hence, specific dimensions and other physical characteristics related to the embodiments disclosed herein are not to be considered limiting.

As used herein, the terms "integral", "unitary", or "monolithic" as used to describe a structure refers to the structure being formed integrally of a continuous material or group of materials with no seams, connections joints, or the like. The integral, unitary structures described herein may be formed through additive manufacturing to have the described structure, or alternatively through a casting process, etc.

In general, the present subject is directed to an electronic component cooling assembly. Specifically, in several embodiments, the electronic component cooling assembly includes an electronic component. The electronic component, in turn, extends in a longitudinal direction from a first end to a second end, in a transverse direction from a first side to a second side, and a vertical direction from a top side to a bottom side. For example, in some embodiments, the electronic component may be a power overlay (POL) semiconductor device having a source layer, a drain layer, and an insulative layer positioned between the source layer and the drain layer.

Furthermore, the electronic component cooling assembly includes a housing, a thermal insert, and a phase change material. More specifically, in several embodiments, the housing defines a slot such that at least a portion of the electronic component is positioned within the slot. Additionally, the housing further defines an impingement cooling passage fluidly coupled to the slot. Moreover, the thermal insert is positioned between the electronic component and the housing in the vertical direction. In this respect, the thermal insert defines a chamber at least partially aligned with the impingement cooling passage in the longitudinal and transverse directions. In addition, the thermal insert defines a cavity spaced apart from the chamber in at least one of the longitudinal and/or transverse directions, with a phase change material positioned in the cavity. In some embodiments, the cavity and the chamber are fluid isolated from each other.

The disclosed electronic component cooling assembly allows the electronic component to operate in an over-power condition, which reduces the size and weight of the electronic component cooling assembly. An over-power condition, in turn, occurs when the electronic component draws more electric power and, thus, generates more heat than a similarly sized conventional cooling assembly can dissipate while keeping the electronic component below its maximum operating temperature. As described above, the impingement cooling passage in the housing and the chamber in the thermal insert are aligned such that the impingement cooling passage can direct a fluid jet onto the electronic component to provide impingement cooling to the electronic component. Such impingement cooling may be suitable during normal operation in non-over-power conditions to keep the electronic component at a suitable operating temperature. Furthermore, the phase change material can absorb additional heat from the electronic component. More specifically, the phase change material can change phases (e.g., from a solid to a liquid) to absorb the increased heat generated by the electronic component during an over-power condition without increasing temperature. Because over-power conditions are short (e.g., less than five minutes) and infrequent (e.g., do not occur during normal operation), the changing of the phase of the phase change material is sufficient to absorb the additional heat generated during the over-power condition without increasing the size of the electronic component cooling assembly beyond what is necessary for cooling the electronic component during normal operation (i.e., non-over-power conditions). Moreover, as described above, the chamber in the thermal insert facilitating impingement cooling and the cavity filled with the phase change material are spaced apart such that the phase change material does not interfere with the impingement cooling while remaining near the electronic component. Such an arrangement allows the disclosed electronic component cooling assembly to be much smaller and lighter than a conventional cooling assembly. This can be particularly advantageous in certain applications, such as aircraft or other aerospace applications where additional weight can significantly increase energy consumption.

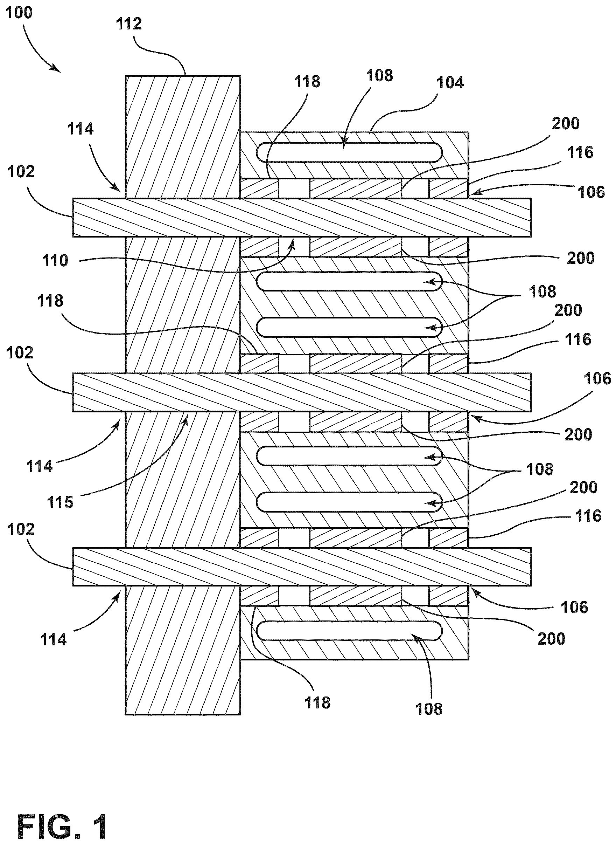

Referring now to the drawings, wherein identical numerals indicate the same elements throughout the figures, FIG. 1 is a simplified cross-sectional view of one embodiment of an electronic component cooling assembly 100 ("assembly 100") in accordance with an exemplary aspect of the present disclosure. In general, the assembly 100 is configured to support (e.g., structurally support) and provide cooling to one or more electronic components 102. In the illustrated embodiment, the assembly 100 supports three electronic components 102. However, in alternative embodiments, the assembly 100 may support more or fewer electronic components 102. Additionally, the assembly 100 may facilitate or enable electrical connection between the electronic component(s) 102 and external conductors or electrical circuits (not shown).

Furthermore, the assembly 100 includes a housing 104. In general, the housing 104 provides structural support for the electronic component(s) 102 and other components used for cooling the electronic component(s) 102. Specifically, in several embodiments, the housing 104 defines one or more slots 106 and one or more cooling plena 108. Each slot 106 is configured to receive one of the electronic components 102 such that at least a portion of each electronic component 102 is positioned within a given slot 106. For example, in some embodiments, a first portion 110 of each electronic component 102 is positioned within one of the slots 106. Moreover, each cooling plenum 108 is configured to provide pressurized air (e.g., cooling air) for use in cooling one or more of the electronic components 102 partially positioned within the housing 104, as will be shown in later figures and described below.

Moreover, the assembly 100 may include a support member 112 coupled to the housing 104. In general, the support member 112 is configured to facilitate or enable electrical connection between the electronic component(s) 102 and external conductor(s)/electrical circuit(s). Specifically, in several embodiments, the support member 112 defines one or more slots 114. Each slot 114 is configured to receive one of the electronic components 102 such that at least a portion of each electronic component 102 is positioned within a given slot 114. For example, in some embodiments, a second portion 115 of each electronic component 102 is positioned within one of the slots 114.

In addition, the assembly 100 includes one or more thermal inserts 200. As will be described below, the thermal insert(s) 200 is configured to provide cooling to the electronic component(s). In the illustrated embodiment, the assembly 100 includes two thermal inserts 200 for each electronic component 102, with one thermal insert 200 positioned above the electric component 102 and another thermal insert 200 positioned below the electronic component 102. However, in alternative embodiments, the assembly 100 may include any other suitable number of thermal inserts 200. For example, in one alternative embodiment, the assembly 100 may include a single thermal insert 200 for each electronic component 102.

Various passages and chambers defined by the housing 104 and the thermal inserts 200 are not shown in FIG. 1 for the purpose of clearly illustrating certain components of the assembly 100. However, these passages and chambers will be shown in later figures and described in detail with respect to these figures below.

In some embodiments, the assembly 100 may include additional components. For example, the assembly 100 may include various seals, such as one or more first seals 116 and/or one or more second seals 118. Specifically, in the illustrated embodiment, one of the first seals 116 and one of the second seals 118 are positioned between each electronic component 102 and the housing 104.

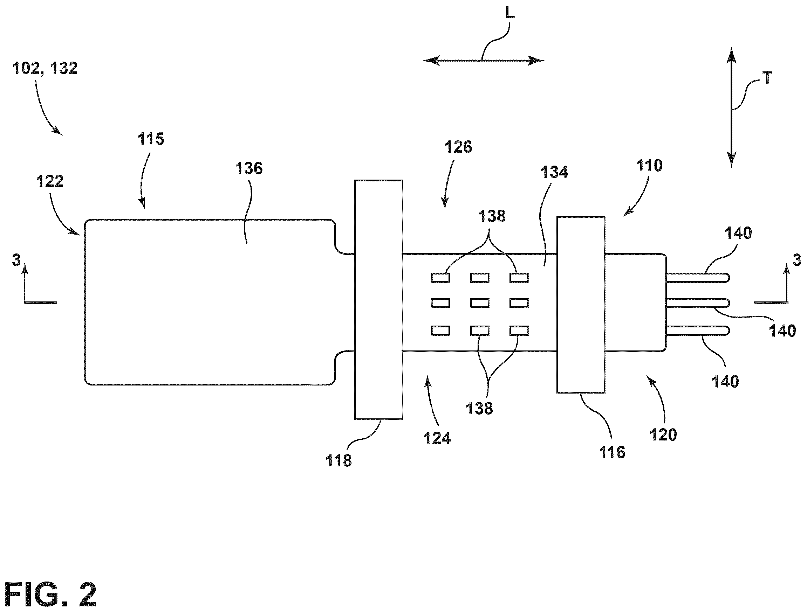

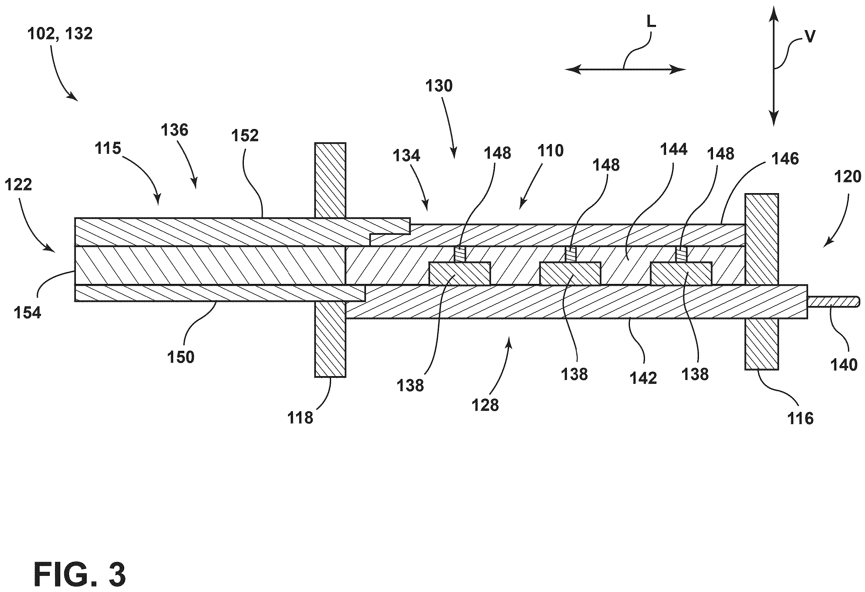

FIGS. 2 and 3 are differing views of one embodiment of the electronic component 102. Specifically, FIG. 2 is a top view of the electronic component 102. Moreover, FIG. 3 is a cross-sectional view of the electronic component 102 taken about Line 3-3 in FIG. 2.

As shown in FIGS. 2 and 3, the electronic component 102 extends in a longitudinal direction L, a transverse direction T, and a vertical direction V. More specifically, the electronic component 102 extends the longitudinal direction L from a first end 120 to a second end 122. Furthermore, the electronic component 102 extends the transverse direction T from a first side 124 to a second side 126. The transverse direction T is, in turn, orthogonal to the longitudinal direction L. Additionally, the electronic component 102 extends the vertical direction V from a bottom side 128 to a top side 130. The vertical direction V is, in turn, orthogonal to the longitudinal direction L and the transverse direction T.

In the embodiment illustrated in FIGS. 2 and 3, the electronic component 102 is configured as a power overlay (POL) semiconductor component 132 ("POL component 132"). However, in alternative embodiments, the electronic component 102 may be configured in any other suitable manner.

As best shown in FIG. 2, in several embodiments, the POL component 132 includes an electronic devices portion 134 and a conductive portion 136. In general, the electronic devices portion 134 is configured to support one or more electronic devices 138, while the conductor end is configured to electrically couple to an external conductor or electrical circuit. More specifically, the electronic devices portion 134 is positioned at or adjacent to the first portion 110 of the POL component 132. Thus, the electronic device portion 134 may be at least partially positioned within one of the slots 106 (FIG. 1) defined by the housing 104 (FIG. 1). Furthermore, as indicated above, the electronic device portion 134 may include the electronic devices 138. The electronic devices(s) 138 can be any suitable type of electric or electronic switching device(s), such as a switching device(s) that includes gate, source, and drain terminals (e.g., a MOSFET-type switch(es)). Although FIG. 2 shows nine electronic devices 138 for clarity, the electronic devices portion 134 may include any suitable number of electronic devices 138. Additionally, the electronic devices portion 134 may include one or more connectors, such as the illustrated pinout connectors 140. Conversely, the conductive portion 136 is positioned at or adjacent to the second portion 115 of the POL component 132. Thus, the conductive portion 136 may be at least partially positioned within one of the slots 114 (FIG. 1) defined by the support member 112 (FIG. 1). In some embodiments, one of the second seals 118 may be positioned at or adjacent to the boundary between the electronic device portion 134 and the conductive portion 136.

Referring particularly to FIG. 3, the electronic devices portion 134 may be formed of a plurality of layers. More specifically, in several embodiments, the electronic devices portion 134 includes an electrically conductive substrate 142 on which the electronic device(s) 138 are positioned. The pinout connectors 140 may be coupled to the electrically conductive substrate 142. Furthermore, the electronic devices portion 134 includes a dielectric layer 144 positioned on top of the electrically conductive substrate 142 and encapsulating the electronic device(s) 138. Moreover, the electronic devices portion 134 includes a top conductive layer 146 positioned on top of the dielectric layer 144. A via 148 may extend through the dielectric layer 144 to electrically couple the top conductive layer 146 and one of the electronic devices 138. However, in alternative embodiments, the electronic devices portion 134 may have any other suitable configuration.

Similarly, the conductive portion 136 may be formed of a plurality of layers. More specifically, in several embodiments, the conductive portion 136 includes a first or bottom conductive layer 150, a second or top conductive layer 152, and an insulating layer 154 positioned between the bottom and top conductive layers 150, 152. The pinout connectors 140 may be coupled to the electrically conductive substrate 142. Furthermore, the electronic devices portion 134 includes dielectric layer 144 positioned on top of the electrically conductive substrate 142 and encapsulating the electronic device(s) 138. Moreover, the electronic devices portion 134 includes a top conductive layer 146 positioned on top of the dielectric layer 144. A via 148 may extend through the dielectric layer 144 to electrically couple the top conductive layer 146 and one of the electronic devices 138. However, in alternative embodiments, the electronic devices portion 134 may have any other suitable configuration.

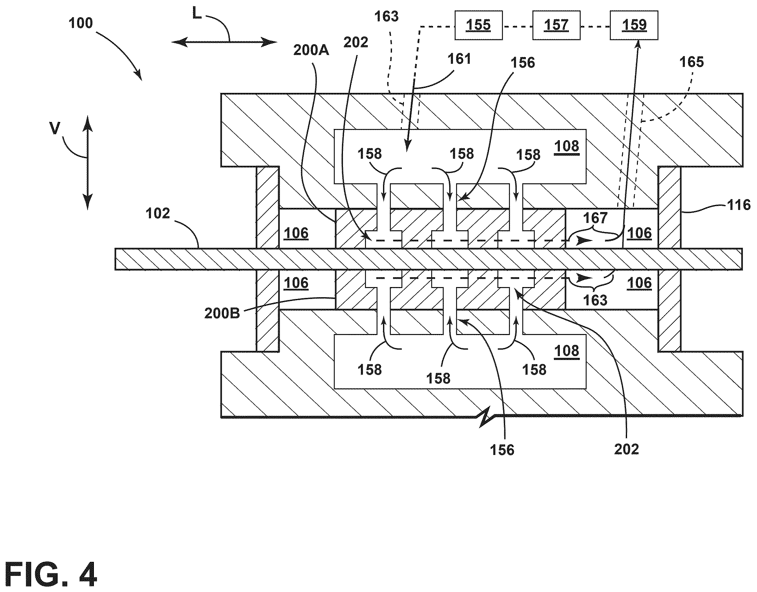

FIG. 4 is a partial, enlarged cross-sectional view of the assembly 100, particularly illustrating the flow of fluid through the assembly 100. For clarity and ease of understanding, the assembly 100 will be described below in the context of a single electronic device 102 positioned within a single slot 106 defined by the housing 104 and in fluid communication with a single plenum 108 defined by the housing 104. However, the structure and operation of the thermal insert(s) 200 will apply similarly to housing 104 having any number of slots 106 for receiving any number of electronic devices 102.

As shown, the housing 104 and the thermal inserts 200A, 200B define various passages and chambers through with a fluid (e.g., air, water, oil, etc.) flows to cool the electronic device 102. More specifically, as indicated above, the housing 104 defines one or more plena 108. In the illustrated embodiment, the housing 104 defines a plenum 108 above the electronic device 102 and another plenum 108 below the electronic device 102. Moreover, as will be described below, the housing 104 further defines one or more impingement cooling passages 156 fluiod coupled to each plenum 108. Additionally, as will be described below, the thermal inserts 200A, 200B define one or more chambers 202 therein. The chamber(s) 202 is, in turn, fluidly coupled to one the plena108 via the impingement cooling passage(s) 156.

In operation, the fluid flows through these passages and chambers to cool the electronic device 102. More specifically, a valve 155 controls the flow of a pressurized fluid 161 generated by a pump 157 from a reservoir 159. In this respect, the pressurized fluid 161 then flows through a passage 163 defined by the housing 104 and into the plena 108. The pressurized fluid 161 in the plena 108 then flows through the impingement cooling passages 156 and into the chamber(s) 202 defined by the thermal inserts 200A, 200B for contact with the electronic component 102. Thereafter, spent fluid 167 is routed from the chamber(s) 202 through the slot 106 and a passage 165 defined by the housing 104 back to the reservoir 159.

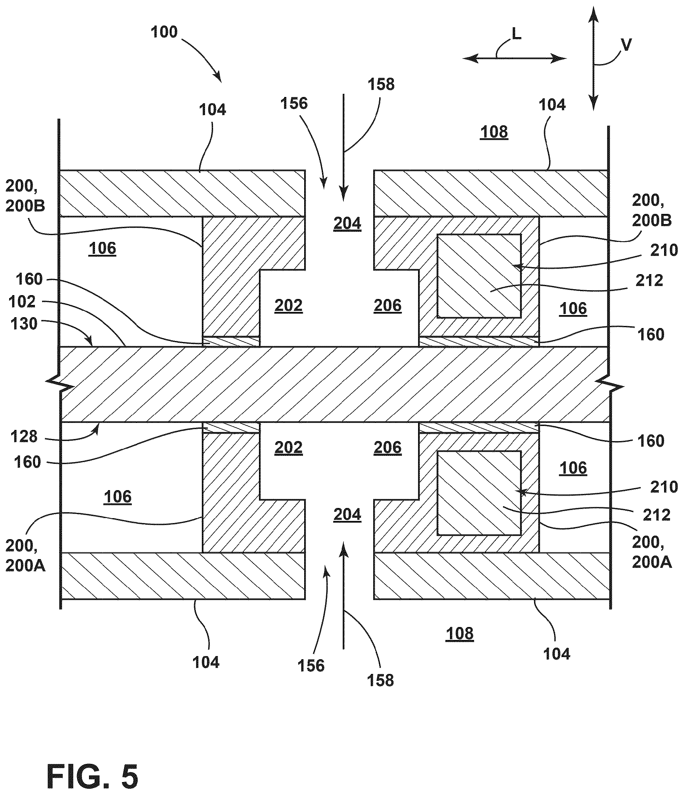

FIG. 5 is another partial, enlarged cross-sectional view of the assembly 100, particularly illustrating the structure and operation of one embodiment of the thermal insert(s) 200. In several embodiments, as mentioned above, the housing 104 of the assembly 100 defines one or more impingement cooling passages 156. For example, the impingement cooling passage(s) 156 is fluidly coupled to the slot 106 and the plenum 108. That is, each impingement cooling passage 156 extends through the housing 104 (e.g., in the vertical direction V) from the plenum 108 to the slot 106. In this respect, each impingement cooling passage 156 is configured to generate a fluid jet 158 (e.g., a jet of air, water, oil, etc.) from pressurized fluid present within the plenum 108 for use in impingement cooling the electronic component 102 positioned within the slot 106. As will be described below, the thermal insert(s) 200 may facilitate delivery of the fluid jet(s) to the electronic component 102.

As indicated above, the thermal insert(s) 200 is positioned between the electronic component 102 and the housing 104 in the vertical direction V. Thus, like the electronic component 102, each thermal insert 200 is at least partially positioned within the slot 106. In the illustrated embodiment, a first thermal insert 200A is positioned between the bottom side 128 of the electronic component 102 and the housing 104. Moreover, in the illustrated embodiment, a second thermal insert 200B is positioned between the top side 130 of the electronic component 102 and the housing 104. However, in alternative embodiments, the assembly 100 may include only the first thermal insert 200A or only the second thermal insert 200B.

In some embodiments, the assembly 100 may include one or more thermally conductive layers 160. More specifically, each thermally conductive layer 160 is positioned between the housing 104 and one of the thermal inserts 200. In this respect, the thermally conductive layer(s) 160 facilitates conductive heat transfer between the electronic component 102 and the thermal insert(s) 200. For example, in one embodiment, the thermally conductive layer 160 can be a layer of silver (e.g., sintered silver). In other embodiments, appropriate solders may be used. However, any low processing temperature sintered metal joint with high thermal conductivity, high strength, and low processing temperature can be used.

As shown in FIG. 5, each thermal insert 200 defines one or more chambers 202 therein. Specifically, in several embodiments, each chamber 202 includes one or more inlet portions 204 and a channel portion 206, with the inlet portion(s) 204 spaced apart from the channel portion 206 in the vertical direction V. As such, the inlet portion(s) 204 is positioned adjacent to the housing 104, while the channel portion 206 is positioned adjacent to the electronic component 102. Moreover, each inlet portion 204 is at least partially aligned with one of the impingement cooling passages 156 in the longitudinal direction L and the transverse direction T. Thus, each inlet portion 204 is fluidly coupled to one of the impingement cooling passages 156. In this respect, the chamber(s) 202 of thermal insert(s) 200 allow the impingement cooling passage(s) 156 to direct the fluid jet(s) 158 into the chamber(s) and onto the electronic component 102. The fluid jet(s) 158, in turn, provide impingement cooling to the electronic component 102. That is, in the embodiment shown in FIG. 5, the fluid jet(s) 158 directly contacts the surface of the electronic device 102.

Furthermore, the assembly 100 includes a phase change material 210. In general, and as will be described below, the phase change material 210 is configured to change phases (e.g., from a solid to a liquid) to absorb the increased heat generated by the electronic component 102 during an over-power condition without increasing temperature. More specifically, each thermal insert 200 defining one or more cavities 212. In this respect, the phase change material 210 is positioned within the cavity(ies) 212 and configured to absorb heat from the electronic component. Additionally, each cavity 212, in turn, is spaced apart from the chamber(s) 202 in at least one of the longitudinal direction L or the transverse direction T. Furthermore, in several embodiments, the cavity(ies) 212 are fluidly isolated from the chamber(s) 202. Thus, the phase change material 210 does not interfere with the impingement cooling provided by the impingement cooling passage 156 while remaining near the electronic component 102 to absorb heat therefrom.

The phase change material 210 may correspond to any suitable material that changes phases at or around a temperature at which the electronic component 102 is to remain below. In some embodiments, this temperature is in the range of 150-200 degrees Celsius. Thus, the phase change material 210 may be, for example, various grades of parrafin wax, hydrated salts, or liquid metals and low melting temperature metals or metal alloys, such as gallium tin.

In some embodiments, such as the embodiment shown in FIG. 5, the thermal insert(s) 200 is electrically insulative. However, as will be described below, in other embodiments, the thermal insert(s) 200 may be electrically conductive.

As indicated above, the thermal insert(s) 200 provides cooling to the electronic component 102. More specifically, during operation, the impingement cooling passages generate fluid jet(s) 158. The alignment of the impingement cooling passage(s) 156 and the inlet portion(s) 204 of the chamber(s) 202 allow the fluid jet(s) 158 to pass through the thermal insert(s) 200 and directly impinge on the exterior surfaces of the electronic component 102. This, in turn, provides impingement cooling to the electronic component 102, which may generally provide sufficient cooling to the electronic component during normal non-over-power conditions.

Furthermore, the phase change material 210 can absorb additional heat from the electronic component 102. More specifically, as described above, the phase change material 210 can change phases (e.g., from a solid to a liquid) to absorb the increased heat generated by the electronic component 102 during an over-power condition without increasing temperature. Because over-power conditions are short (e.g., less than five minutes) and infrequent (e.g., do not occur during normal operation), the changing of the phase of the phase change material 210 is sufficient to absorb the additional heat generated during the over-power condition without increasing the size of the electronic component 102 cooling assembly beyond what is necessary for cooling the electronic component during normal operation (i.e., non-over-power conditions). Moreover, as described above, the chamber(s) 202 and the cavity(ies) 212 filled with the phase change material 210 are spaced apart such that the phase change material 210 does not interfere with the impingement cooling while remaining near the electronic component 102.

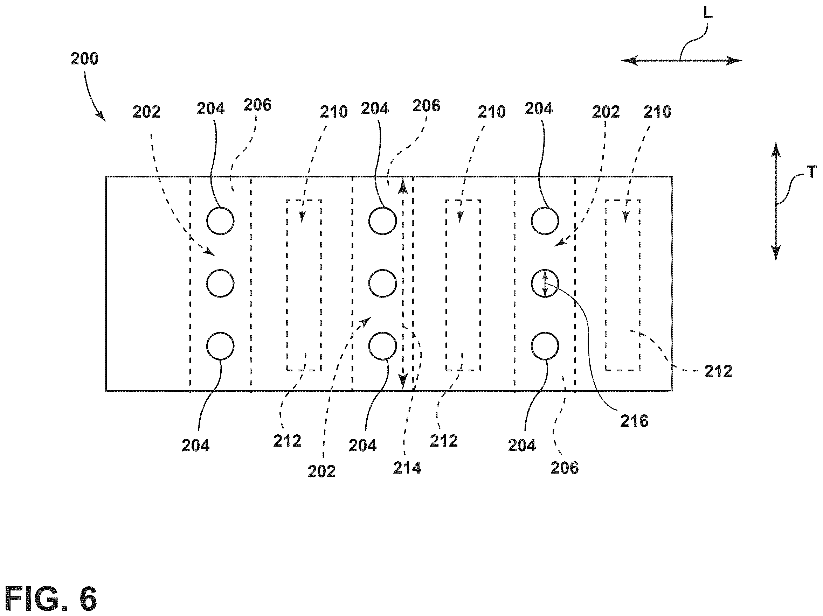

FIG. 6 is a top view of one of the thermal inserts 200. As mentioned above, the thermal insert 200 includes the chamber(s) 202, with each chamber 202 including the inlet portion(s) 204 and a channel portion 206. In the illustrated embodiment, the thermal insert 200 includes three chambers 202. However, in alternative embodiments, the thermal insert 200 may include more or fewer chambers 202. Additionally, in the illustrated embodiment, each chamber 202 includes three inlet portions 204 fluidly coupled to a single channel portion 206. The inlet portions 204 are spaced apart from each other in at least one of the longitudinal direction L or the transverse direction T. However, in alternative embodiments, each chamber 202 may include more or fewer inlet portions 204.

In several embodiments, the channel portion 206 may be wider than the inlet portion(s) 204. For example, in such embodiments, the largest dimension of the channel portion 206 in the transverse direction T (indicated by dashed arrow 214) is greater than the largest dimension of the inlet portion(s) 204 in the transverse direction T (indicated by solid arrow 216).

In some embodiments, the thermal insert 200 may be constructed via additive manufacturing. As described herein, the presently disclosed subject matter involves the use of additive manufacturing machines or systems. As used herein, the term "additive manufacturing" refers generally to manufacturing technology in which components are manufactured in a layer-by-layer manner. An exemplary additive manufacturing machine may be configured to utilize any suitable additive manufacturing technology. The additive manufacturing machine may utilize an additive manufacturing technology that includes a powder bed fusion (PBF) technology, such as a direct metal laser melting (DMLM) technology, a selective laser melting (SLM) technology, a directed metal laser sintering (DMLS) technology, or a selective laser sintering (SLS) technology. In an exemplary PBF technology, thin layers of powder material are sequentially applied to a build plane and then selectively melted or fused in a layer-by-layer manner to form one or more three-dimensional objects. Additively manufactured objects are generally monolithic and may have a variety of integral sub-components.

Additionally, or alternatively, suitable additive manufacturing technologies may include, for example, Fused Deposition Modeling (FDM) technology, Direct Energy Deposition (DED) technology, Laser Engineered Net Shaping (LENS) technology, Laser Net Shape Manufacturing (LNSM) technology, Direct Metal Deposition (DMD) technology, Digital Light Processing (DLP) technology, and other additive manufacturing technologies that utilize an energy beam or other energy source to solidify an additive manufacturing material such as a powder material. Any suitable additive manufacturing modality may be utilized with the presently disclosed subject matter.

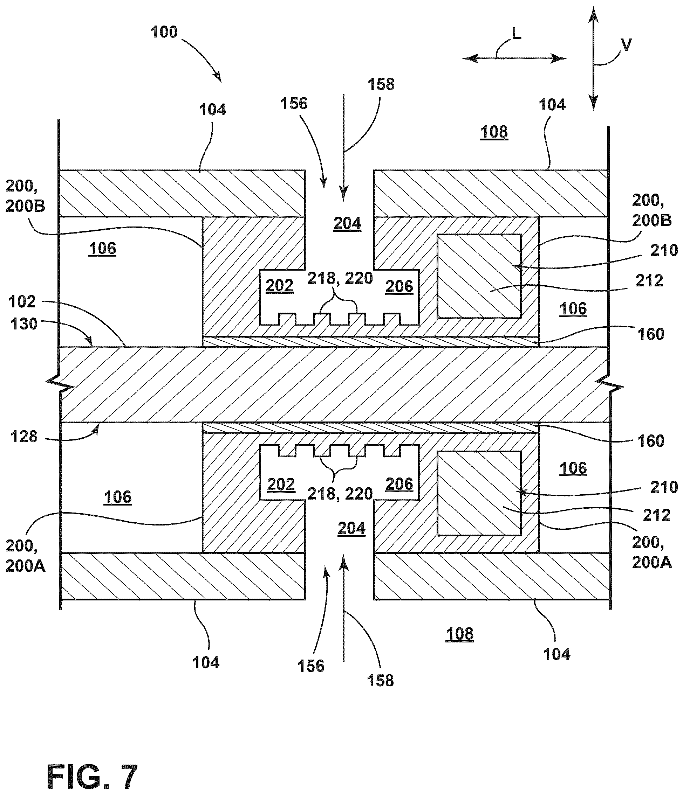

FIG. 7 is a partial, enlarged cross-sectional view of the assembly 100, particularly illustrating the structure and operation of another embodiment of the thermal insert(s) 200. Like the embodiment shown in FIG. 5, the thermal insert(s) 200 of FIG. 7 defines one or more chambers 202, each having one or more inlet portions 204 and a channel portion 206. Additionally, like the embodiment shown in FIG. 5, the thermal insert(s) 200 of FIG. 7 defines one or more cavities 212 filled with a phase change material 210. However, unlike the embodiment shown in FIG. 5, the thermal insert(s) 200 of FIG. 7 includes a surface roughening feature 218 positioned within the channel portion 206 of each chamber 202. In this respect, the fluid jet(s) 158 impinges on the surface roughening features 218, which, in turn, is in contact with the electronic component 102 via the thermally conductive layer 160. The surface roughening feature 218, in turn, provides additional cooling to electronic component 102 by increasing the surface area across which the fluid jet(s) 158 impinges. For example, in some embodiments, the surface roughening feature 218 may be configured as a plurality of fins 220. As such, a portion of at least one fin 220 is aligned with each impingement cooling passage 156 in the longitudinal direction L and the transverse direction T. However, in alternative embodiments, the surface roughening feature 218 may be configured as any other suitable feature to increase surface area, such as a plurality of pins.

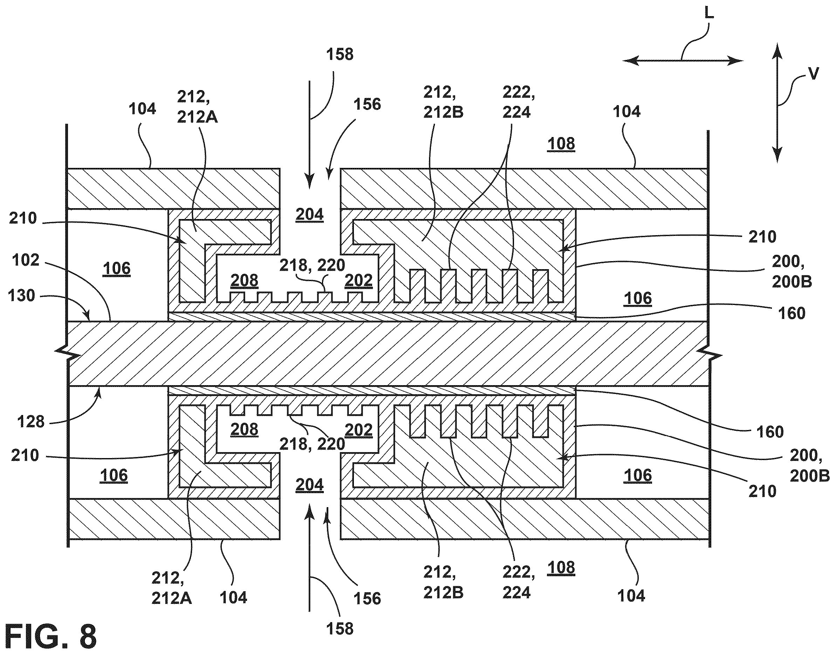

FIG. 8 is a partial, enlarged cross-sectional view of the assembly 100, particularly illustrating the structure and operation of a further embodiment of the thermal insert(s) 200. Like the embodiment shown in FIG. 7, the thermal insert(s) 200 of FIG. 8 defines one or more chambers 202, each having one or more inlet portions 204 and a channel portion 206. Additionally, like the embodiment shown in FIG. 7, the thermal insert(s) 200 of FIG. 8 defines one or more cavities 212 filled with a phase change material 210. Moreover, like the embodiment shown in FIG. 7, the thermal insert(s) 200 of FIG. 8 includes the surface roughening feature 218 (e.g., the fins 220) positioned within the channel portion 206 of each chamber 202. However, unlike the embodiment shown in FIG. 7, the thermal insert(s) 200 of FIG. 8 includes a surface roughening feature 222 positioned within the cavity 212 filled with the phase change material 210. In this respect, the surface roughening feature 222 provides additional cooling to the electronic component 102 by increasing the surface area of the thermal insert(s) 200 exposed to the phase change material 210. For example, in some embodiments, the surface roughening feature 222 may be configured as a plurality of fins 224. However, in alternative embodiments, the surface roughening feature 222 may be configured as any other suitable feature to increase surface area, such as a plurality of pins.

Additionally, unlike the embodiment shown in FIG. 7, each thermal insert 200 of FIG. 8 includes two cavities 212 filled with the phase change material 210. For example, each thermal insert 200 may include a first cavity 212A positioned on one side of the chamber 202 and a second cavity 212B positioned on the other side of the chamber 202. In the illustrated embodiment, the first cavity 212A is devoid of the surface roughening feature 222, while the second cavity 212B includes the roughening feature 222. However, in alternative embodiments, the first cavity 212A may include the surface roughening feature 222, while the second cavity 212B may be devoid of the roughening feature 222. Alternatively, both the first and second cavities 212A, 212B may include the surface roughening feature 222.

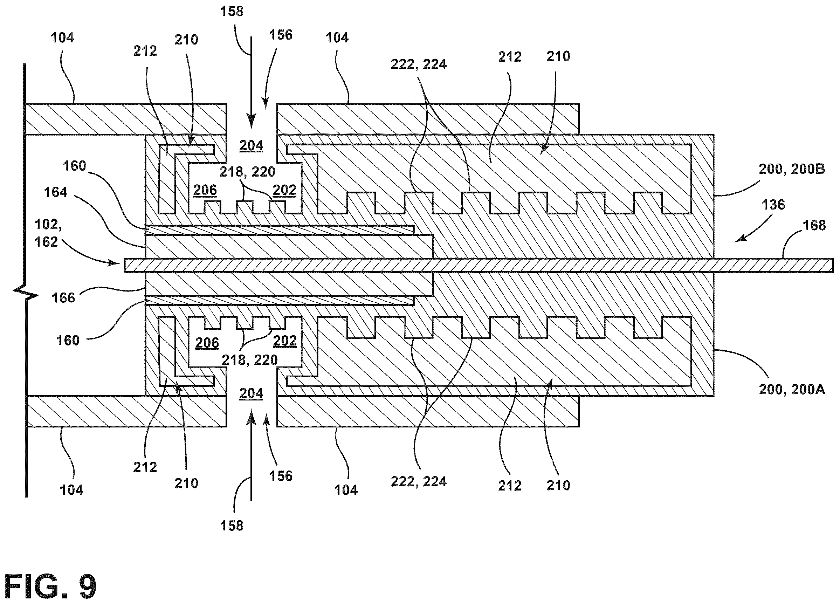

FIG. 9 is a partial, enlarged cross-sectional view of the assembly 100, particularly illustrating the structure and operation of yet another embodiment of the thermal insert(s) 200. Like the embodiment shown in FIG. 8, the thermal insert(s) 200 of FIG. 9 defines one or more chambers 202, each having one or more inlet portions 204 and a channel portion 206. Additionally, like the embodiment shown in FIG. 7, the thermal insert(s) 200 of FIG. 8 defines one or more cavities 212 filled with a phase change material 210. Moreover, like the embodiment shown in FIG. 7, the thermal insert(s) 200 of FIG. 8 includes the surface roughening feature 218 (e.g., the fins 220) positioned within the channel portion 206 of each chamber 202 and the surface roughening feature 222 (e.g., the fins 224) positioned within the cavity(ies) 212.

However, unlike the embodiment shown in FIG. 8, the thermal insert(s) 200 of FIG. 9 is electrically conductive. More specifically, the embodiment shown in FIG. 9, the electronic component 102 is a power overlay (POL) semiconductor device 162 having a source layer 164, a drain layer 166, and an insulative layer 168 positioned between the source layer 164 and the drain layer 166 (e.g., in the vertical direction V). In this respect, the first thermal insert 200A is electrically coupled to the drain layer 166, and the second thermal insert 200B is electrically coupled to the source layer 164. Moreover, the first and second thermal inserts 200A, 200B may extend beyond the source and drain layers 164, 166 (e.g., in the longitudinal direction L) such that the first and second thermal inserts 200A, 200B form the conductive portion 136 of the electronic component 102. That is, the first and second thermal inserts 200A, 200B may form part of the electrical coupling between the source and drain layers 164, 166 and the external conductors or electrical circuits (not shown).

As described above, the disclosed electronic component cooling assembly allows an electronic component to operate in an over-power condition, which reduces the size and weight of the electronic component cooling assembly. Specifically, during an overpower condition, the phase change material can absorb additional heat from the electronic component without increasing in temperature. Moreover, this can be done without increasing increasing the size of the electronic component cooling assembly beyond what is necessary for cooling the electronic component during normal operation (i.e., non-over-power conditions). For example, in aerospace applications, there may be situations when the electronic component must handle large amounts of power for a short period time (e.g., when raising and/or lowering the landing gear, deploying flaps or making major adjustments to the positions of other large control surfaces, etc.). Thus, the disclosed electronic component cooling assembly allows smaller and lighter electronic components (e.g., POL semiconductor devices) to be used in the control of such systems and components, which can reduce the energy consumption of the aircraft.

Further aspects are provided by the subject matter of the following clauses:
An electronic component cooling assembly, includes an electronic component extending in a longitudinal direction from a first end to a second end, in a transverse direction from a first side to a second side, and a vertical direction from a top side to a bottom side; a housing defining a slot such that at least a portion of the electronic component is positioned within the slot, the housing further defining an impingement cooling passage fluidly coupled to the slot; a thermal insert positioned between the electronic component and the housing in the vertical direction, the thermal insert defining a chamber such that the impingement cooling passage directs a fluid jet into the chamber and onto the electronic component, the thermal insert further defining a cavity spaced apart from the chamber in at least one of the longitudinal direction or the transverse direction; and a phase change material positioned within the cavity and configured to absorb heat from the electronic component.

The assembly of one or more clauses, wherein the cavity is fluidly isolated from the chamber.

The assembly of one or more clauses, wherein: the chamber comprises an inlet portion and a channel portion, the inlet portion spaced apart from the channel portion in the vertical direction, and a largest dimension of the channel portion in the transverse direction is greater than a largest dimension of the inlet portion in the transverse direction.

The assembly of one or more clauses, wherein the inlet portion corresponds to a first inlet portion, the chamber further including a second inlet portion spaced apart from the first inlet portion in at least one of the longitudinal direction or the transverse direction.

The assembly of one or more clauses, wherein the inlet portion of the chamber is at least partially aligned with the impingement cooling passage in the longitudinal direction and the transverse direction.

The assembly of one or more clauses, wherein the thermal insert comprises a surface roughening feature positioned within the channel portion of the chamber.

The assembly of one or more clauses, wherein the surface roughening feature comprises a plurality of fins.

The assembly of one or more clauses, wherein a portion of at least one fin of the plurality of fins is aligned with the impingement cooling passage in the longitudinal direction and the transverse direction.

The assembly of one or more clauses, wherein the thermal insert comprises a surface roughening feature positioned within the cavity.

The assembly of one or more clauses, wherein the surface roughening feature comprises a plurality of fins.

The assembly of one or more clauses, further comprising: a support member coupled to the housing, the support member defining a slot, wherein the electronic component comprises a first portion positioned adjacent to the first end and a second portion positioned adjacent to the second end, the first portion positioned within the slot of the housing, the second portion positioned within the slot of the support member.

The assembly of one or more clauses, wherein the thermal insert comprises a first portion positioned within the slot of the housing and a second portion positioned within the slot of the support member.

The assembly of one or more clauses, wherein the electronic component is a power overlay (POL) semiconductor device comprising a source layer, a drain layer, and an insulative layer positioned between the source layer and the drain layer.

The assembly of one or more clauses, wherein the thermal insert is electrically insulative.

The assembly of one or more clauses, wherein the thermal insert is electrically coupled to the source layer.

The assembly of one or more clauses, wherein the thermal insert is electrically coupled to the drain layer.

The assembly of one or more clauses, wherein the impingement cooling passage corresponds to a first impingement cooling passage, the thermal insert corresponds to a first thermal insert positioned between the top side of the electronic component and the housing and defining a first chamber, and the phase change material corresponds to a first phase change material, the assembly further comprising: a second thermal insert positioned between the bottom side of the electronic component and the housing in the vertical direction, the second thermal insert defining a second chamber such that a second impingement cooling passage defined by the housing directs a fluid jet into the second chamber and onto the bottom side of the electronic component, the second thermal insert further defining a second cavity spaced apart from the second chamber in at least one of the longitudinal direction or the transverse direction; and a second phase change material positioned within the second cavity and configured to absorb heat from the electronic component.

An electronic component cooling assembly, comprising: a power overlay (POL) semiconductor component comprising a source layer, a drain layer, and an insulative layer extending between the source layer and the drain layer; a housing defining a slot such that at least a portion of the POL semiconductor component is positioned within the slot; a thermal insert positioned between the POL semiconductor component and the housing, the thermal insert defining a cavity; and a phase change material positioned within the cavity and configured to absorb heat from the POL semiconductor component.

The assembly of one or more clauses, wherein: the housing defines an impingement cooling passage fluidly coupled to the slot, and the thermal insert defines a chamber such that the impingement cooling passage directs a fluid jet into the chamber and onto the POL semiconductor component, the thermal insert further defining a cavity spaced apart from the chamber in at least one of a longitudinal direction or a transverse direction.

The assembly of one or more clauses, wherein the chamber is spaced apart from the cavity.

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. An electronic component cooling assembly, comprising:
an electronic component extending in a longitudinal direction from a first end to a second end, in a transverse direction from a first side to a second side, and a vertical direction from a top side to a bottom side;
a housing defining a slot such that at least a portion of the electronic component is positioned within the slot, the housing further defining an impingement cooling passage fluidly coupled to the slot;
a thermal insert positioned between the electronic component and the housing in the vertical direction, the thermal insert defining a chamber such that the impingement cooling passage directs a fluid jet into the chamber and onto the electronic component, the thermal insert further defining a cavity spaced apart from the chamber in at least one of the longitudinal direction or the transverse direction; and
a phase change material positioned within the cavity and configured to absorb heat from the electronic component.

2. The assembly of claim 1, wherein the cavity is fluidly isolated from the chamber.

3. The assembly of claim 1 or 2, wherein:
the chamber comprises an inlet portion and a channel portion, the inlet portion spaced apart from the channel portion in the vertical direction, and
a largest dimension of the channel portion in the transverse direction is greater than a largest dimension of the inlet portion in the transverse direction.

4. The assembly of claim 3, wherein the inlet portion corresponds to a first inlet portion, the chamber further including a second inlet portion spaced apart from the first inlet portion in at least one of the longitudinal direction or the transverse direction.

5. The assembly of claim 3 or 4, wherein the inlet portion of the chamber is at least partially aligned with the impingement cooling passage in the longitudinal direction and the transverse direction.

6. The assembly of any of claims 3 to 5, wherein
the thermal insert comprises a surface roughening feature positioned within the channel portion of the chamber,
optionally, the surface roughening feature comprises a plurality of fins, and
optionally, a portion of at least one fin of the plurality of fins is aligned with the impingement cooling passage in the longitudinal direction and the transverse direction.

7. The assembly of any preceding claim, wherein
the thermal insert comprises a surface roughening feature positioned within the cavity, and
optionally, the surface roughening feature comprises a plurality of fins.

8. The assembly of any preceding claim, further comprising:
a support member coupled to the housing, the support member defining a slot,
wherein the electronic component comprises a first portion positioned adjacent to the first end and a second portion positioned adjacent to the second end, the first portion positioned within the slot of the housing, the second portion positioned within the slot of the support member; wherein
optionally, the thermal insert comprises a first portion positioned within the slot of the housing and a second portion positioned within the slot of the support member.

9. The assembly of any preceding claim, wherein the electronic component is a power overlay (POL) semiconductor device comprising a source layer, a drain layer, and an insulative layer positioned between the source layer and the drain layer.

10. The assembly of claim 9, wherein the thermal insert is electrically insulative.

11. The assembly of claim 9 or 10, wherein the thermal insert is electrically coupled to the source layer.

12. The assembly of claim 9 or 10, wherein the thermal insert is electrically coupled to the drain layer.

13. The assembly of any preceding claim, wherein the impingement cooling passage corresponds to a first impingement cooling passage, the thermal insert corresponds to a first thermal insert positioned between the top side of the electronic component and the housing and defining a first chamber, and the phase change material corresponds to a first phase change material, the assembly further comprising:
a second thermal insert positioned between the bottom side of the electronic component and the housing in the vertical direction, the second thermal insert defining a second chamber such that a second impingement cooling passage defined by the housing directs a fluid jet into the second chamber and onto the bottom side of the electronic component, the second thermal insert further defining a second cavity spaced apart from the second chamber in at least one of the longitudinal direction or the transverse direction; and
a second phase change material positioned within the second cavity and configured to absorb heat from the electronic component.

14. An electronic component cooling assembly, comprising:
a power overlay (POL) semiconductor component comprising a source layer, a drain layer, and an insulative layer extending between the source layer and the drain layer;
a housing defining a slot such that at least a portion of the POL semiconductor component is positioned within the slot;
a thermal insert positioned between the POL semiconductor component and the housing, the thermal insert defining a cavity; and
a phase change material positioned within the cavity and configured to absorb heat from the POL semiconductor component.

15. The assembly of claim 14, wherein:
the housing defines an impingement cooling passage fluidly coupled to the slot,
the thermal insert defines a chamber such that the impingement cooling passage directs a fluid jet into the chamber and onto the POL semiconductor component, the thermal insert further defining a cavity spaced apart from the chamber in at least one of a longitudinal direction or a transverse direction, and
optionally, the chamber is spaced apart from the cavity.
